Europäisches Patentamt

(19) European Patent Office

Office européen des brevets

(11) Numéro de publication: **0 114 536**
**B1**

## (12) FASCICULE DE BREVET EUROPEEN

(45) Date de publication du fascicule du brevet:
22.06.88

(51) Int. Cl.⁴: **G 01 R 15/12,** G 01 R 19/25

(21) Numéro de dépôt: 83402060.4

(22) Date de dépôt: 24.10.83

(54) **Appareil de mesure multi-sondes.**

(30) Priorité: 03.12.82 FR 8220364

(43) Date de publication de la demande:
01.08.84 Bulletin 84/31

(45) Mention de la délivrance du brevet:
22.06.88 Bulletin 88/25

(84) Etats contractants désignés:
BE CH DE GB IT LI NL SE

(56) Documents cités:
ELECTRONIC DESIGN, vol. 29, no. 21, 15 octobre 1981,
Denvilie, NJ (US) R. ALLAN: "DVMs, DMMs advance on
2 fronts: low cost, systems performance" pages
129-146
TM TECHNISCHES MESSEN, vol. 47, no. 9, septembre
1980, Munich (DE) H. PREISSINGER:
"Messwerterfassung mit Mikroprozessoren", pages
307-312.
TOUTE L'ELECTRONIQUE, no. 439, janvier 1979, Paris
(FR) "Les voltmètres "système" ", pages 19-28.
BBC-NACHRICHTEN, vol. 54, septembre/octobre 1972,
Mannheim (DE) K.O. HOFFMANN: "Wirkungsweise und
Einsatz von digitalen Messgeräten", pages 241-252.

(73) Titulaire: SOLOMAT FRANCE S.A., Les Bouleaux,
F-91160 Ballainvilliers (FR)

(72) Inventeur: Ibar, Jean Pierre, 3, rue Jean Jaurès, Vililers
sur Orge (Essonne) (FR)
Inventeur: Saffell, John Robert, Poltimore Farway,
Barton (near Exeter) (GB)

(74) Mandataire: Cabinet Pierre HERRBURGER,
115, Boulevard Haussmann, F-75008 Paris (FR)

## Description

La présente invention concerne un appareil de mesure multi-sondes à structure modulaire, pour mesurer des grandeurs électriques ou liées à des grandeurs électriques et afficher les résultats ou les transmettre à des utilisateurs, selon le préambule de la revendication 1.

En effet, un tel appareil est connu selon le document ELECTRONIC DESIGN, volume 29, numéro 21, 15 Octobre 1981. Cet appareil connu comporte une unité centrale, des modules détachables liant l'unité centrale aux capteurs par des liaisons électriques qui s'établissent en même temps que se fait la liaison mécanique entre le module et l'unité centrale, et chaque module comporte des circuits de traitement liés aux capteurs que peut recevoir le module.

Les appareils de mesure se composent, sous leur forme la plus simple, d'un capteur et d'un circuit électronique de traitement des signaux fournis par le capteur ainsi que d'un moyen d'affichage ou plus généralement d'un système de sortie.

La conception et la fabrication des appareils de mesure voient un regain de développement car les capteurs et les convertisseurs analogiquesnumériques deviennent plus précis et moins coûteux, les moyens d'affichage et les circuits de commande se perfectionnent et l'utilisation de microprocesseurs sur plaquette unique permet une faible consommation.

Ces différents développements qui ont modifié la conception des appareils de mesure apparaissent clairement lorsqu'il s'agit d'appareils de mesure portatifs. Alors qu'anciennement les thermomètres ou les pH mètres portatifs ne faisaient pas plus que de déplacer une aiguille devant une échelle ou un affichage numérique, on trouve maintenant sur le marché des instruments ou appareils plus élaborés. Ces appareils peuvent se classer comme suit:

1) Les appareils dont la fonction est de faire un ou deux types de mesure avec affichage numérique. Ces appareils utilisent les progrès industriels cités ci-dessus principalement dans le but de réduire le coût de l'instrument.

2) Les appareils dotés d'un microprocesseur pouvant faire un ou deux types de mesure, mais qui se présentent sous une forme et utilisation très souples et pratiques. Un exemple de ces appareils est un voltmètre mesurant des résistances, des tensions et des intensités. Une commutation sur l'appareil permet de passer d'une mesure à une autre.

3) Les centrales de mesure de type universel qui peuvent accepter un très grand nombre de signaux d'entrée mais nécessitent une adaptation spécifique des circuits électroniques à chaque type de capteurs et des programmes spécifiques pour l'analyse des données. Ces appareils ne sont pas, en général, portatifs et leur utilisation nécessite l'achat de capteurs bien spécifiques correspondant au conditionnement électronique câble dans l'appareil. Leur sophistication est telle que, bien souvent, ils fournissent des sorties analogiques et numériques des signaux traités.

La présente invention a pour but de créer un appareil qui combine les avantages des appareils de mesure de type 2 et 3. Ce nouveau type d'instrument utilise un microprocesseur pour effectuer les tâches suivantes:

1) rendre l'appareil plus apte à interpréter un signal d'entrée et fournir les résultats à l'affichage avec une résolution adaptée,

2) rendre l'appareil plus polyvalent pour qu'il accepte une grande diversité de capteurs sans conditionnement électronique supplémentaire,

3) donner une plage complète de signaux de sortie analogiques et numériques qui permettent d'actionner des relais de régulation et l'enregistrement des paramètres mesurés.

Cet appareil est très difficile à concevoir pour diverses raisons, principalement:

1) Il existe une grande diversité de capteurs qui mesurent une même grandeur physique par des techniques différentes et qui nécessitent chacun un circuit de traitement électronique spécifique.

2) Cette grande diversité de signaux d'entrée à traiter est accrue si l'on cherche à mesurer différentes grandeurs physiques et nécessite également des linéarisations et des mises à l'échelle différentes ainsi que différentes unités d'affichage pour les différentes mesures.

Etant donné ces deux difficultés, un appareil portatif multi-sondes susceptible d'interpréter une grande variété de signaux d'entrée nécessiterait l'utilisation d'un trop grand nombre de circuits électroniques supplémentaires pour traiter les différents capteurs et une mémoire de très grande capacité pour enregistrer les informations relatives aux différentes constantes de linéarisation, mise à l'échelle et formatage d'affichage.

La présente invention a pour but de créer un appareil multi-sondes permettant de traiter une grande variété de mesures en plus des mesures classiques telles que des résistances (ohms), tensions (volts), intensité (ampères) et fréquences (Hertz) comme cela est fait par des appareils existant déjà.

L'appareil doit notamment pouvoir traiter des signaux concernant des mesures de pH, de concentration, de pourcentage d'humidité relative RH, de température, de pression, de distance, de vitesse d'écoulement d'un fluide ou de débit, de conductivité, etc. . . , pouvoir linéariser correctement le signal d'entrée, corriger l'influence de la température si besoin est, mettre le résultat en unités correctes, modifier la sortie en fonction des instructions de l'utilisateur et fournir des données à la fois pour un affichage optique et des données analogiques/numériques.

L'invention a également pour but de créer un appareil ayant un nombre minima de circuits de traitement du type intégré et à caractère universel pour traiter des signaux électriques provenant de plus d'un type de capteurs.

L'invention a également pour but de créer un appareil suceptible de recevoir une information numérique d'un des circuits de traitement ci-dessus, pour déterminer le type de capteur utilisé, l'unité de mesure, la résolution recherchée ainsi que d'autres informations appropriées.

L'invention a également pour but de créer un appareil permettant de réduire l'espace mémoire nécessaire pour l'enregistrement des données de linéarisation des capteurs et leur mise à l'échelle.

L'invention a également pour but de créer un appareil répondant à certains ordres de l'utilisateur y compris:

1) choix de la résolution et de l'unité de mesure,

2) lecture de la valeur minimale, maximale, de la valeur moyenne,

3) Sortie des données correspondantes: données d'affichage, données analogiques et données numériques en parallèle et en série.

A cet effet, l'invention propose un appareil selon la revendication 1.

L'appareil modulaire est une solution nouvelle des appareils portatifs, car cela permet à l'utilisateur d'acheter d'abord une unité principale qui comporte le microprocesseur, le convertisseur A/D ou tout autre circuit d'acquisition des signaux d'entrée, les composants de précision, l'affichage numérique, et le circuit de sortie, ainsi que l'alimentation. Les modèles s'acquièrent séparément et en fonction des besoins des utilisateurs et ils constituent l'interface pour les différents capteurs ou groupes de capteurs. Ces modules sont conçus dans le but de couvrir par l'acquisition d'un seul module à multicapteurs, ou d'un nombre réduit de modules, l'ensemble des mesures de grandeurs physiques que l'utilisateur veut mesurer.

Grâce à l'utilisation de la formule de linéarisation de type

$$X = A_0 + A_1 + \frac{(A_2 + X)^1 \ (A_3 + X)^m .....}{(A_2{}' + X)^{1'} \ (A_3{}' + X)^{m'} .....}$$

$$1 + m + ... + 1' + m' + .... = 1$$

et le calcul des constantes à conserver en mémoire par intégration de la mise à l'échelle et de la linéarisation dans la même formule, on réduit considérablement la capacité de mémoire nécessaire. De plus, la valeur des constantes en mémoire permet également de tenir compte de la non-linéarité possible des circuits de traitement et combiner ainsi l'ensemble des facteurs de non-linéarité.

Cette possibilité de combinaison dans la formule de linéarisation des corrections de non-linéarité du circuit électronique de traitement et de la mise à l'échelle, permet l'utilisation d'un seul circuit de traitement pour conditionner les entrées de plusieurs capteurs différents.

Dans le cas le plus général, les signaux analogiques fournis par le ou les capteurs, sont transmis à un convertisseur. Le convertisseur est généralement un convertisseur analogique numérique A/D combiné à un commutateur électronique qui choisit alternativement l'une ou l'autre des deux voies sur lesquelles sont branchés les deux capteurs. Les signaux ainsi transmis à l'unité principale sont traités séparément sous forme numérique suivant la formule de linéarisation et de compensation donnée ci-dessus et dont les paramètres sont définis par le module en fonction des capteurs qui ont été branchés. Ce n'est qu'après ce traitement indépendant que les deux résultats de mesure sont combinés pour donner le résultat destiné à l'affichage ou à l'exploitation.

De façon schématique, l'appareil, selon l'invention, combine une information numérique et une information analogique entre le module et l'unité centrale, l'information numérique étant fournie par le module en fonction du type de capteur et par la nature du capteur lui-même alors que l'information analogique correspond au résultat de la mesure par le capteur.

L'unité centrale interroge le module pour déterminer quel symbole à utiliser à l'affichage, quel type de capteur correspondant à ce symbole (par exemple, pour la mesure de température, s'il s'agit de thermocouple, de thermistance, de résistance au platine, etc. ) ou pour les anèmomètres à fil chaud ou à hélice tournante.

Ce module donne la résolution pour l'affichage et des renseignements sur la nature du signal électronique à l'entrée, par exemple s'il s'agit d'un signal de niveau bas ou de niveau haut: toutes ces interrogations résultent dans des décisions au niveau du traitement du signal d'entrée, son conditionnement et sa linéarisation. Il se renseigne pour savoir s'il lit 1 ou 2 entrées.

Ce système d'interrogation est universel et s'applique au traitement de chaque capteur. Le microprocesseur, connaissant toutes les informations numériques résultant de l'interrogation, envoie le signal par exemple au convertisseur A/D.

Il y a une différence totale entre les divers centrales de mesure qui existent actuellement et l'appareil selon l'invention.

Les différences se situent au niveau des signaux selon la présente invention, l'interaction entre le capteur et l'unité centrale (au travers du module) est particulièrement simple pour l'utilisateur, plus polyvalente et plus souple par le regroupement de tous les traitements dans l'unité centrale et grâce à l'interrogation numérique faite par l'unité centrale dans le module.

En effet, dans les centrales de mesure, il y a un circuit de conditionnement associé à un capteur déterminé donc autant de circuits que de capteurs alors que, dans l'invention, les circuits de conditionnement sont universels: les variables qui changent en fonction du capteur choisi, étant déterminés au moment de l'acquisition des données par l'interrogation numérique du module par l'unité centrale. Cet appareil assure une nouvelle combinaison des signaux d'entrée par un agencement logique plus perfectionné du traitement de l'information se traduisant sur le plan électronique par une réduction très importante du nombre de circuits de conditionnement, c'est-à-dire par l'universalité de ces circuits.

L'appareil peut ainsi recevoir un très grand nombre de capteurs sans calibrage particulier ou compliqué nécessitant une modification des circuits.

Suivant une autre caractéristique importante, l'appareil permet de mesurer deux grandeurs simultanément et de façon totalement indépendante, par exemple la température, permettant de compenser l'effet de cette variable (température) sur la variable que l'on veut mesurer.

Grâce aux deux entrées (ports), le signal à mesurer est appliqué sur l'un des ports, l'autre recevant le signal de compensation (par exemple température). On peut ainsi utiliser des capteurs très différents, la lecture du 2e port servant à la compensation de la variable sans nécessiter de circuit spécifique.

En résumé, une centrale de mesure est bâtie autour d'un certain capteur particulier; pour utiliser un autre capteur, l'utilisateur doit normaliser de nouveau son capteur et recalibrer pour pouvoir utiliser les traitements internes figés à l'avance, de la centrale de mesure.

Contrairement à cela, l'appareil selon l'invention peut recevoir une grande variété de capteurs sans distinction grâce au circuit de conditionnement et d'interrogation.

Cette structure de l'appareil de mesure, consistant à regrouper dans l'unité centrale le maximum de circuits et de réaliser des modules aussi simples que possible qui assurent l'adaptation de familles de capteurs, permet d'augmenter les séries de fabrication de l'unité centrale qui, quoique complexe, restera d'un coût relativement faible, alors que les modules, plus spécifiques mais d'une structure simple, ne seront pas non plus coûteux.

La linéarisation des signaux dans l'unité centrale simplifie la structure des modules et en réduit le coût. En effet, les paramètres de linéarisation sont fournis par le module lorsque celui-ci est branché sur l'unité centrale ou lorsque le ou les capteurs choisis sont branchés sur le module (par l'intermédiaire du sélecteur). De ce fait, certains capteurs peuvent avoir une réponse non linéaire sans que cela ne complique le module sur lequel ils sont branchés.

Cette identification du capteur permet non seulement d'effectuer le traitement approprié du signal mais également de commander l'affichage suivant les unités appropriées, etc . . .

Il y a donc une double compensation des signaux, d'une part, au niveau du module et, d'autre part, au niveau du programme de traitement dans l'unité centrale.

La jonction entre le module et l'unité centrale assure le contact électrique entre les deux éléments pour:

– l'alimentation, la ligne de masse et la tension de référence, fournies par l'unité principale au module,

– l'information numérique envoyée par le module à l'unité centrale, lorsque cet échange est demandé par l'unité centrale.

– L'envoi des signaux analogiques ou des impulsions de cadence du module vers le convertisseur analogique/numérique lorsque cela est demandé par l'unité centrale.

La combinaison d'informations analogiques en parallèle et d'informations numériques en série réduit le nombre de contacts nécessaires entre l'unité centrale et le module par exemple.

A titre d'exemple, l'ensemble des lignes d'interface est réduit à 15 lignes, mais ce nombre n'est pas critique, et le minimum de lignes étant probablement 4. Le choix de 15 est surtout basé sur l'utilisation de la prise à 15 voies qui est standard, bon marché et très fiable.

Suivant une autre caractéristique, les informations identifiant les capteurs commandent les paramètres de la linéarisation des signaux numériques correspondant aux signaux analogiques dans l'unité centrale de traitement.

Suivant une autre caractéristique, les circuits de traitement assurent la compensation suivant différents paramètres tels que la température, la pression.

Suivant une autre caractéristique, l'unité centrale comporte des moyens pour commander l'affichage de grandeurs telles que: minimum, maximum, moyenne, ou pour bloquer l'affichage pendant une durée déterminée.

Suivant une autre caractéristique, chaque module comporte un sélecteur pour sélectionner un mode de fonctionnement.

La présente invention sera décrite plus en détail à l'aide des dessins annexés, dans lesquels:

– La figure 1 est un schéma d'ensemble d'un appareil, selon l'invention,

– La figure 2 est une vue de face de l'appareil montrant l'unité centrale et un module.

– La figure 3 est une vue de dos de l'appareil selon la figure 2.

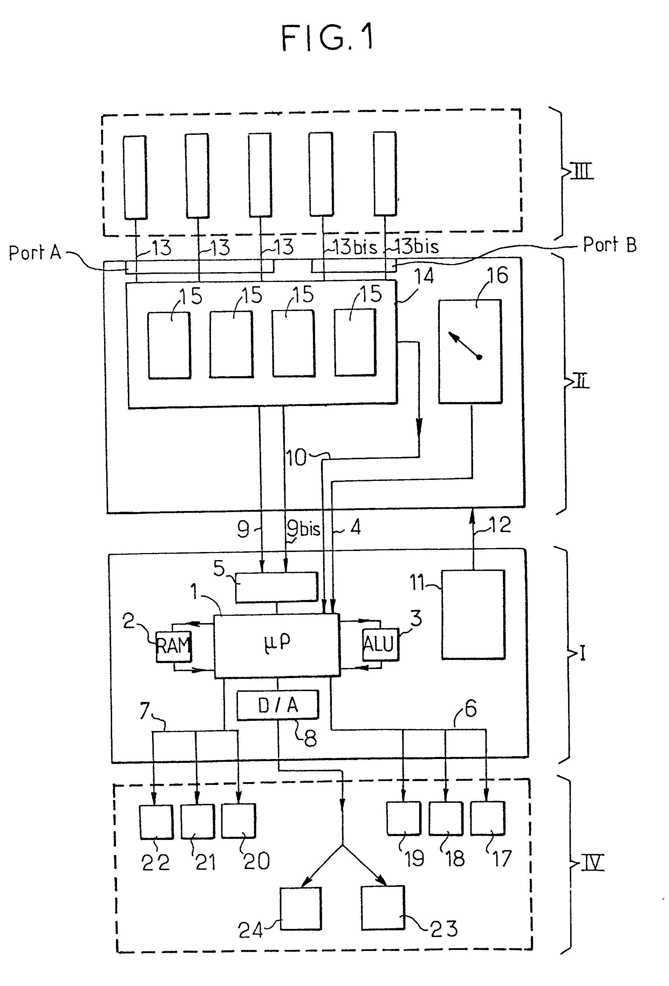

Selon la figure 1, l'appareil se compose de quatre parties, à savoir:

L'unité centrale I qui assure la gestion de l'ensemble de l'appareil.

Des modules II qui font la liaison entre les capteurs et l'unité centrale I.

Des capteurs III, tels que des capteurs de température, de pression, etc . . . qui fournissent des signaux électriques analogiques.

Des circuits utilisateurs IV, tels que des circuits d'affichage, de commande, etc . . .

L'unité centrale I se compose d'un microprocesseur I relié à une mémoire vive RAM 2, à une unité arithmétique et logique ALU 3. L'accès au microprocesseur 1 se fait soit directement lorsqu'il s'agit de signaux numériques par la ligne 4, soit indirectement par le convertisseur 5. La sortie se fait soit sous forme numérique parallèle par le bus 6 ou numérique série par le bus 7 soit sous forme analogique par le convertisseur DLA 8 (numérique/analogique).

Ces sorties 6, 7, 8 sont reliées aux circuits utilisateurs IV.

L'unité centrale est reliée à un module par les bus 4, 9, 9bis, servant à l'échange de signaux entre le module II et l'unité centrale I et par le bus 10 servant à la transmission d'ordres de l'unité centrale I vers le module II: L'unité centrale I comporte également une alimentation électrique II, par exemple une pile ou une batterie, reliée non seulement aux circuits de l'unité centrale I, mais également au module II par la ligne 12.

Les lignes 9, 9bis sont deux lignes de transmission de signaux analogiques venant de deux capteurs traités de façon indépendante dans le module pour être reçus et traités indépendamment dans l'unité centrale I et n'être combinés qu'en fin de traitement.

Toutefois, le module peut n'être branché que sur un capteur (pour la mesure d'une seule grandeur ou lorsqu'il n'y a pas compensation de la grandeur mesurée).

De façon simple, comme un seul circuit de traitement reçoit les signaux de deux capteurs, le convertisseur 5 est combiné à un commutateur électronique qui branche en alternance l'une ou l'autre voie.

Dans le cas le plus usuel, le convertisseur est un convertisseur analogique/numérique A/D. Il peut toutefois également s'agir par exemple d'un convertisseur tension/fréquence.

La ligne 10 sert à l'interrogation du module II par l'unité centrale I; cette interrogation se fait par un échange de signaux numériques permettant notamment à l'unité centrale I de connaître le type de mesure à effectuer, le type de capteur utilisé, la nature du signal et l'utilisation d'un ou deux capteurs.

Le type de mesure signifie qu'il s'agit d'une mesure de température, de PH, de RH, d'anémométrie, etc...

Le type de capteur permet de déterminer les constantes de linéarisation et de conditionnement, telles que l'échelle de mesure, la résolution de la mesure, la correction des erreurs systématiques, c'est-à-dire propres au système.

La nature du signal permet de savoir si un circuit tel qu'un filtre passe-haut ou passe-bas doit être branché, etc...

De façon plus détaillée, les liaisons électriques entre l'unité centrale I et le module II se font au moment de la mise en place du module II.

Le programme de traitement exécuté par l'unité centrale a plusieurs buts:

– Vérifier le fonctionnement correct.

– Interroger le module pour connaître le type de capteur, l'unité de mesure, le type de conditionnement de signal et la résolution. Le module répond par une information numérique codée.

– Utiliser l'information numérique du module, mettre en œuvre et mesurer le signal du capteur avec soit le convertisseur analogique/numérique, soit avec le circuit d'entrée en cadence. Le cas échéant, le circuit mesure également la température pour en tenir compte si une compensation en température doit être faite.

– Appliquer une équation de linéarisation aux données d'entrée mis sous forme numérique. Toutes les lectures faites par les capteurs sont corrigées en température, sont linéarisées et mises à l'échelle.

– Vérifier les ordres que l'utilisateur introduit par les touches et relatives au calcul des grandeurs telles que minimum, moyenne ou maximum; changement de format des données de sortie.

– Fournir en sortie les données à l'affichage et des sorties numériques ainsi que des données au convertisseur numérique/analogique et à la commande de ce convertisseur.

Le microprocesseur 1 exécute quatre travaux distincts:

1) Lecture des lignes d'entrée de signal numérique,

2) Lecture et commande du convertisseur analogique/numérique ou de l'entrée de fréquence,

3) Exécution de la linéarisation, de la compensation en température et de la mise à l'échelle des signaux d'entrée,

4) Génération de signaux de sortie correspondant au résultat pour l'affichage, le convertisseur numérique-analogique et la sortie numérique en code BCD.

Le microprocesseur est par exemple un microprocesseur en technique CMOS à huit bits.

Le convertisseur analogique-numérique (A/D) 5 est par exemple un convertisseur en technique CMOS à double pente à 13 bits, signés. Il effectue des conversions sur un rythme de 20 conversions à la seconde, mais l'affichage est seulement renouvelé trois fois par seconde: le microprocesseur fait l'addition de quatre lectures puis la moyenne numérique pour fournir un signal à 12 bits signés.

Le convertisseur A/D 5 est commandé par le microprocesseur 1. Le microprocesseur 1 lit le convertisseur A/D 5 ou l'entrée de fréquence. Le microprocesseur 1 commande également les lignes d'entrée du convertisseur A/D 5. Le microprocesseur 1 choisit l'entrée analogique normale, soit l'entrée analogique à compensation de température. Suivant le module utilisé, le convertisseur A/D mesure seulement l'entrée normale ou le cas échéant si une compensation de température est nécessaire, il ne lit que l'entrée avec compensation de température. L'entrée de fréquence est commandée de façon interne par le microprocesseur. Le circuit comporte un oscillateur à cristal à 3,579 MHZ qui donne la base de temps; la précision de la fréquence d'entrée dépend totalement de la précision du cristal de l'oscillateur.

Suivant l'état de la ligne de commande, le microprocesseur accepte un signal sur 16 conversions. Cette solution est intéressante pour effectuer des mesures sur une pèriode très longue.

La tension de référence de 2000 volts est générée par deux références de tension, à intervalle stable. Cette tension assure le calibrage du convertisseur D/A et passe en sortie sur le module sur une ligne d'impédance constante.

La sortie analogique peut être positive ou négative. La sortie du convertisseur numérique-analogique (D/A) 8 est toujours la même que la sortie parallèle BCD.

L'alimentation se fait par des piles ou des batteries susceptibles d'être chargées lorsque l'unité centrale est en fonctionnement ou à l'arrêt.

Les avantages de l'unité centrale sont les suivantes:
- simplicité de fonctionnement,
- bonne durée de vie de la batterie,
- bonne tenue en main,
- composant fiable,
- sortie analogique et numérique,
- alimentation alternative,
- souplesse de réalisation, avec un pied, un élément anti-vol et un dispositif de montage,
- affichage numérique clair,
- faible coût.

Les modules II susceptibles d'être mis en place sur l'unité centrale I sont réalisés de façon à pouvoir recevoir différents capteurs ou familles de capteurs; ainsi, en moyenne, chaque module est prévu pour une dizaine de capteurs.

Chaque module II comporte des entrées 13, 13bis regroupés sur des port A et port B constitués par exemple par deux paires de broches, multiples, sur lesquelles se branchent les prises correspondantes de capteurs. Les capteurs III sont reliés à un circuit de commutation 14 assurant la commutation des capteurs sur les circuits de traitement ou de correction 15 eux-mêmes reliés par commutation aux lignes 9, 9bis respectives.

En pratique, le branchement des capteurs IV sur les fiches est codé suivant les broches de façon que le module reconnaisse le(s) capteur(s) branché(s).

Bien que, dans le cas le plus général, les convertisseurs soient intégrés à l'unité centrale, il est également envisageable de les reporter dans les modules.

La mise en œuvre de l'un ou de plusieurs des circuits de traitement et de correction est réalisée par le circuit de commande 16. Ce circuit de commande 16 assure la mise en œuvre des circuits de correction 15 soit en reconnaissant le branchement des capteurs sur les entrées 13, soit par action manuelle de l'utilisateur sur le bouton de sélection.

Le circuit de commutation 14 est relié au bus 10 pour recevoir les ordres de l'unité centrale I par exemple une cadence de l'horloge, un signal d'échantillonnage pour l'envoi des signaux par le bus 9.

Les informations relatives à l'identité du module II, du ou des capteurs reliés au module, du type de compensation commandé par le circuit 16 sont transmises à l'unité centrale I pour que celle-ci puisse en tenir compte pour le traitement des signaux.

Un module déterminé est prévu pour chacun des quatre types de circuits en conditionnement:
a) un circuit à compensation de température,
b) un circuit nécessitant la linéarisation,
c) un circuit de conditionnement avec différentes informations numériques pour différents modules de façon à obtenir un module à fonction multiple,
d) un circuit spécialisé pour des applications déterminées.

Les modules peuvent également mélanger des circuits par exemple permettre la compensation en température et les applications multi-fonctionnelles, etc. ...

A titre d'exemple, les modules II se fixent mécaniquement sur l'unité centrale I par deux sortes de moyens:

1) Un connecteur à quinze broches pour assurer la liaison des lignes des signaux analogiques/ numériques et des signaux de commande. Ce type de connecteurs est autoporteur.

2) De plus, le module pénètre sur une certaine longueur dans le boîtier de l'unité centrale pour renforcer la rigidité de la liaison avec deux griffes de verrouillage.

Les modules présentent un certain nombre d'avantages importants:
- adaptation en sécurité sur l'unité centrale,
- faible coût
- souplesse de conception,
- module s'adaptant à une très grande diversité de capteurs, existants ou à convenir,
- meilleure précision grâce à la commande par le microprocesseur de l'unité centrale,
- Mesure de toutes les principales variables utilisées.

Ces modules permettent de résoudre les différents problèmes de conception auxquels il faut remédier, notamment pour l'interface analogique et la linéarisation d'un très grand nombre de capteurs différents. Le coût, la précision et la fiabilité ont été pris en compte de façon égale.

Les capteurs III constituent la troisième partie de l'appareil.

Il est important de permettre à l'utilisateur d'utiliser les nombreux capteurs existants servant à mesurer la température, le pH, l'oxygène, la vitesse d'écoulement d'un fluide (vent), déjà sur le marché. Il existe de façon générale plus de 100 capteurs de mesure de la température de mesure chimique et de mesure d'environnement qui peuvent fonctionner directement avec cet appareil.

Pour fonctionner avec ces 100 capteurs, il faut un minimum de 8 modules et une unité principale. L'avantage qui en découle est que l'utilisateur n'a besoin que d'un seul appareil principal pour tous ses besoins de mesure normale; l'appareil est modulaire. Il peut donc s'étendre à des mesures supplémentaires ultérieurement.

Les capteurs peuvent être répartis en différents groupes auxquels correspondent des modules II différents.

Le premier groupe de capteurs nécessite une compensation en température avec éventuellement une linéarisation particulière.

Le second groupe correspond à différents capteurs de température donnant des signaux non linéaires qui doivent être affichés sous forme de signaux linéaires.

Le troisième groupe de capteurs correspond à ceux mesurant des grandeurs relatives à l'environnement et qui, de ce fait, doivent être regroupées pour pouvoir être mesurées en utilisant un même module.

Les différents circuits ou appareils utilisateurs IV sont branchés sur les sorties 6, 7, 8 de l'unité centrale I. La sortie numérique parallèle 6 est par exemple prévue pour être reliée à une commande ou alarme 17, une imprimante 18 ou un interface IEEE 19.

La sortie numérique série 7 est prévue pour être reliée par exemple à une transmission à distance 20, à un affichage à distance 21, ou à l'affichage de l'appareil 22 par exemple un affichage à diode LED ou de préférence à un affichage à cristaux liquides LCD.

L'affichage numérique est commandé par un compteur à quatre demi-chiffres, le microprocesseur 1 fournit en sortie un train d'impulsions dont le nombre est égal à l'affichage. Ces impulsions sont comptées puis affichées sur l'afficheur LCD; les impulsions sont comptées et converties en format BCD et verrouillées pour la sortie BCD. Les symboles d'affichage sont envoyés sous forme de quatre bits codés, envoyés à l'affichage. La virgule décimale, les symboles «Mini», «Maxi» et «Moyenne» sont commandés par le microprocesseur.

La sortie analogique 8 est reliée soit à une commande 23, soit à un dispositif d'enregistrement 24.

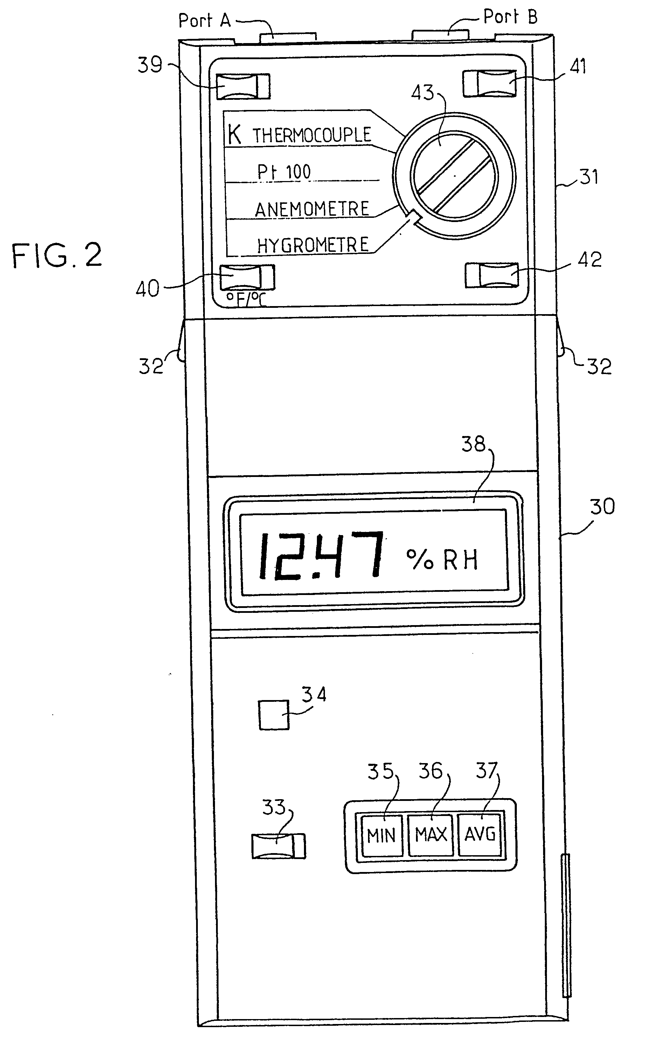

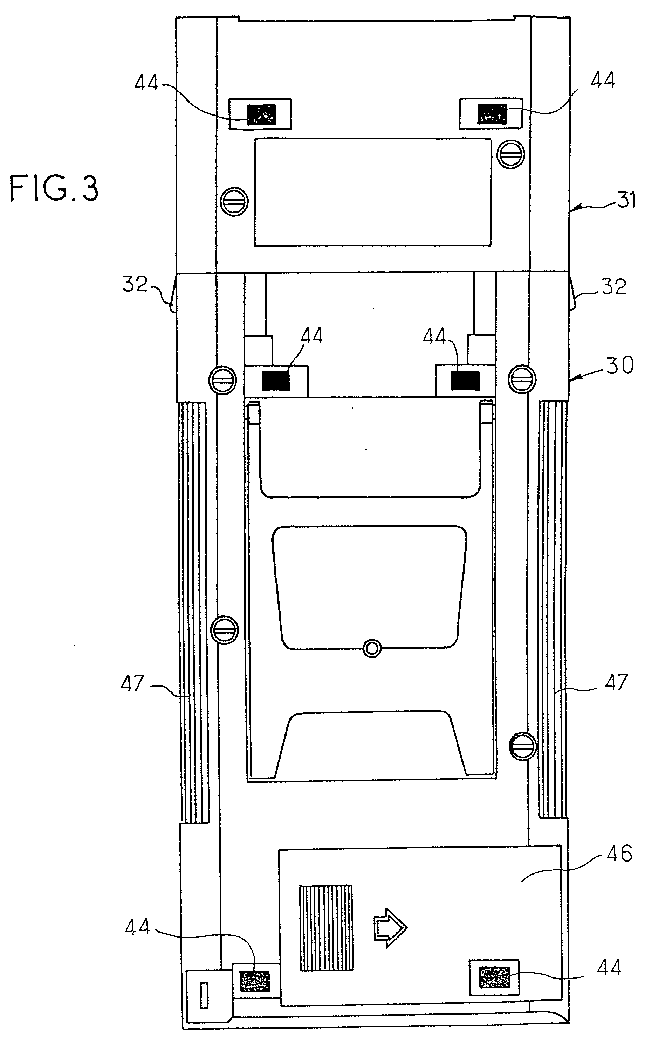

Les figures 2 et 3 montrent un mode de réalisation particulier de l'unité centrale I et d'un module II.

Selòn la figure 2, l'unité centrale I se compose d'un boîtier 30 auquel se relie par emboîtage le boîtier 31 d'un module II. Les branchements électriques se font en même temps que la mise en place du boîtier 31 sur le boîtier 30; la liaison mécanique par emboîtage est complétée par des organes de verrouillage 32.

Sur sa face avant, le boîtier 30 comporte les boutons suivants:

Bouton 33; Ce bouton commande la marche, l'arrêt: Il s'agit par exemple d'un commutateur coulissant (les batteries peuvent se charger même lorsque l'appareil est arrêté).

Bouton 34: Il assure le blocage de l'affichage sur le dernier nombre affiché.

Bouton 35: Il commande l'affichage de la plus petite grandeur (Min) mesurée depuis le début de la mesure.

Bouton 36: Il commande l'affichage de la plus grande grandeur (Max) mesurée depuis le début de la mesure.

Bouton 37: Il commande l'affichage de la moyenne (AVG) des mesures.

La face avant est également occupée par le dispositif d'affichage 38 de préférence à cristaux liquides LCD.

L'affichage est commandé par le microprocesseur de la manière suivante:

1) Lors de la mise en marche de l'appareil, il apparaît sur l'affichage un nombre tel que par exemple un 8888 qui garantit que tous les segments d'affichage fonctionnent correctement. Les virgules apparaissent également.

2) L'affichage assure la remise à l'échelle automatique en cas de dépassement.

3) L'affichage de code d'erreurs par exemple:
– pour le dépassement de la plage du convertisseur A/D,

– si l'utilisateur demande une résolution supérieure à celle qui est possible,
– en l'absence du signal d'entrée pour certaines mesures.

4) Les zéros en avant du chiffre affiché sont effacés dans la mesure où ces zéros sont inutiles.

La face avant du boîtier 31 comporte différents boutons de fonctionnement 39, 40, 41, 42 correspondant, par exemple, à la mise en œuvre d'un filtre au choix d'une échelle de température, au choix d'une compensation de température, etc... Le choix du capteur se fait par le bouton sélecteur 43 qui commande en même temps le dispositif 16 (figure 1). Dans l'exemple représenté, il s'agit de différents capteurs de température, c'est-à-dire de différents thermocouples.

Selon la figure 3, la face arrière des boîtiers 30, 31 comporte des patins 43 anti-dérapants ainsi qu'un pied 44 escamotable. Cette figure montre également le volet 46 du logement à piles ou batteries et les nervures 47 anti-dérapantes facilitant la préhension.

### Revendications

1. Appareil de mesure multi-sondes à structure modulaire pour mesurer des grandeurs électriques ou liées à des grandeurs électriques fournies par des capteurs (III) et afficher les résultats ou les transmettre à des utilisateurs, appareil formé d'une unité centrale (I) d'au moins un module détachable (II), faisant la liaison entre l'unité centrale (I) et le ou les capteurs (III), ce module (II) étant associé à un ou plusieurs capteurs (III) déterminés, ce module (II) étant lui-même relié (4, 9, 10) à l'unité centrale (I) par des liaisons électriques s'établissant en même temps que se fait la liaison mécanique entre le module (II) et l'unité centrale (I), chaque module (II) comportant des circuits de traitement (15) liés aux capteurs (III) et assurant la compensation suivant différents paramètres tels que la température et la pression que peut recevoir ce module (II), appareil caractérisé en ce que chaque module (II) comporte en outre un circuit de commande (16) et un circuit de commutation (14) pour commuter le capteur (III) sur un circuit de traitement associé (15) et lui fournir, d'une part, le signal de mesure par un port (A) et un signal de compensation par un autre port (B), en fonction de la reconnaissance du branchement du capteur (III) sur l'entrée (13) (port A, port B) ou d'une action manuelle sur le circuit de commande (16), le circuit de commande (16) étant relié par une ligne (4) à l'unité centrale (I) pour lui fournir un signal d'identification du (des) capteur(s) (III) et le circuit de commutation (14) étant relié par deux voies distinctes (9, 9bis) à l'unité centrale (I) qui reçoit et traite de façon distincte et indépendante les signaux des deux voies pour les combiner, l'unité centrale (I) comportant des circuits d'acquisition comprenant un convertisseur (5) et un accès direct (4) de signaux d'entrée formés des signaux de mesure et des signaux d'identification des capteurs reliés au circuit de commutation (14) et au circuit de commande (16) du module (II) pour fournir des signaux à un circuit de traitement à mémoire (1, 2, 3) alimentant les moyens d'affichage et de sortie de signaux pour des utilisateurs (19, 24).

2. Appareil selon la revendication 1, caractérisé en ce que le convertisseur (5) est un convertisseur analogique/numérique ou un convertisseur tension/fréquence combiné à un commutateur de voies.

3. Appareil selon l'une quelconque des revendications 1 et 2, caractérisé en ce que le convertisseur (5) est intégré à un module.

4. Appareil selon la revendication 1, caractérisé en ce que les signaux d'identification des capteurs sont des signaux numériques et les signaux de mesure sont des signaux analogiques.

5. Appareil selon la revendication 1, caractérisé en ce que les informations identifiant les capteurs (III) commandent les paramètres de la linéarisation des signaux numériques correspondant aux signaux analogiques dans l'unité centrale de traitement (I).

6. Appareil selon la revendication 1, caractérisé en ce que l'unité centrale (I) comporte des moyens (34–37) pour commander l'affichage de grandeurs telles que: minimum, maximum, moyenne, ou pour bloquer l'affichage pendant une durée déterminée.

7. Appareil selon la revendication 1, caractérisé en ce que chaque module (II) comporte un sélecteur (16, 43) pour sélectionner un mode de fonctionnement. ·

**Claims**

1. A multi-probe measuring apparatus with a modular structure for measuring electrical values or values connected with electrical values supplied by pick-ups (III) and displaying the results or transmitting them to users, said apparatus being formed by a central unit (I) comprising at least one detachable module (II), forming the connection between the central unit (I) and the pick-up or pick-ups (III), this module (II) being associated with one or more given pick-ups (III), this module (II) itself being connected (4, 9, 10) to the central unit (I) by electrical connections which are formed at the same time as the mechanical connection between the module (II) and the central unit (I), each module (II) comprising processing circuits (15) connected to the pick-ups (III) and compensating according to different parameters such as temperature and pressure which this module (II) can receive, said apparatus being characterised in that each module (II) also comprises a control circuit (16) and a switching circuit (14) to switch the pick-up (III) to an associated processing circuit (15) and supply it firstly with the measuring signal through a port (A) and a compensating signal through another port (B) depending on recognition of connection of the pick-up (III) to the input (13) (port A, port B) or manual operation of the control circuit (16), the control circuit (16) being connected by a line (4) to the central unit (I) to supply a signal to identify the pick-up or pick-ups (III) and the switching circuit (14) being connected by two separate channels (9, 9a) to the central unit (I) which receives and processes the signals from the two channels separately and independently to combine them, the central unit (I) comprising acquisition circuits comprising a converter (5) and a direct access (4) for input signals formed from the measuring signals and the signals for identification of the pick-ups connected to the switchin circuit (14) and to the control circuit (16) of the module (II) to supply signals to a processing circuit with a memory (1, 2, 3) feeding the means for displaying and outputting signals for users (19, 24).

2. An apparatus as in claim 1, characterised in that the converter (5) is an analogue/digital converter or a voltage/frequency converter combined with a channel selector.

3. An apparatus as in any one of claims 1 and 2, characterised in that the converter (5) is integrated into a module.

4. An apparatus as in claim 1, characterised in that the signals for identifying the pick-ups are digital signals and in that in the measurement signals are analogue signals.

5. An apparatus as in claim 1, characterised in that the information identifying the pick-ups (III) control the parameters for the linearisation of the digital signals corresponding to the analogue signals in the central processing unit (I).

6. An apparatus as in claim 1, characterised in that the central unit (I) comprises means (34–37) to control the display of values such as minimum, maximum, mean, or to inhibit the display for a given time.

7. An apparatus as in claim 1, characterised in that each module (II) comprises a selector (16, 43) to select an operating mode.

**Patentansprüche**

1. Mehrsonden-Messvorrichtung in Modulbauweise zum Messen von elektrischen Grössen oder mit elektrischen Grössen verbunden, die von Aufnehmern (III) geliefert werden, und zum Anzeigen oder Weiterleiten der Ergebnisse, eine Vorrichtung, die aus einer zentralen Einheit (I) von wenigstens einem entfernbaren Modul (II) gebildet wird, das die Verbindung zwischen der zentralen Einheit (I) und dem oder den Aufnehmern bildet, wobei das Modul (II) mit einem oder mehreren bestimmten Aufnehmern (III) und selbst mit der zentralen Einheit (I) durch elektrische Leitungen verbunden ist (4, 9, 10), die gleichzeitig durch die mechanische Verbindung zwischen dem Modul (II) und der zentralen Einheit (I) ausgebildet sind, und wobei jedes Modul Verarbeitungskreise (15) umfasst, die mit den Aufnehmern (III) verbunden sind und die die Kompensation gemäss unterschiedlicher Parameter wie Temperatur und Druck sicherstellen, die das Modul (II) erhalten kann, dadurch gekennzeichnet, dass jedes Modul (II) eine Steuerkreis (16) und einen Schaltkreis (14) umfasst, um den Aufnehmer (III) auf einen angeschlossenen Verarbeitungskreis (15) umzuschalten und ihm einerseits das Messsignal durch ein Tor (A) und ein Kompensationssignal durch ein anderes Tor (B) beim Erkennen der Verzweigung des Aufnehmers (III) am Eingang (13) (Tor A, Tor B) oder durch ein manuelles Verfahren auf den Steuerkreis (16) zu liefern, dass der Steuerkreis (16) durch eine Leitung (14) mit der zentralen Einheit (I) verbunden ist, um ihm ein Identifikationssignal des bzw. der Aufnehmer (III) zu liefern, dass der Schaltkreis (14) über zwei verschiedene Wege (9, 9bis) mit der zentralen Einheit (I) verbunden ist, die auf unterschiedliche und unabhängige Weise die Signale der zwei Wege empfängt und verarbeitet, um sie zu kombinieren, dass die zentrale Einheit (I) Erfassungskreise mit einem Konverter (5) und einem direkten Eingang (4) der Eingangssignale umfasst, die aus den Messsignalen und den Identifikationssignalen der Aufnehmer gebildet werden, die mit dem Schaltkreis (14) und dem Steuerkreis (16) des Moduls (II) verbunden sind, um Signale an einen Speicherverarbeitungskreis (1, 2, 3) zu leiten, der die Verwender (19, 24) mit den Mitteln zur Anzeige und zum Signalausgang versorgt.

2. Vorrichtung nach Anspruch 1, dadurch gekennzeichnet, dass der Konverter (5) ein Analog-/ Digital-Konverter oder ein Spannungs-/Frequenz-Konverter ist, der mit einer Wegschaltung kombiniert ist.

3. Vorrichtung nach einem der Ansprüche 1 und 2, dadurch gekennzeichnet, dass der Konverter (5) in einem Modul integriert ist.

4. Vorrichtung nach Anspruch 1, dadurch gekennzeichnet, dass die Identifikationssignale der Aufnehmer digitale Signale und die Messsignale Analogsignale sind.

5. Vorrichtung nach Anspruch 1, dadurch gekennzeichnet, dass die die Aufnehmer (III) identifizierenden Informationen die Parameter der Linearisierung der digitalen Signale steuern, die den Analogsignalen in der zentralen Verarbeitungseinheit (I) entsprechen.

6. Vorrichtung nach Anspruch 1, dadurch gekennzehnet, dass die zentrale Einheit (I) Mittel (34–37) zum Steuern der Anzeige von Grössen wie Minimum, Maximum, Mittel oder zum Blockieren der Anzeige während eines bestimmten Zeitraums umfasst.

7. Vorrichtung nach Anspruch 1, dadurch gekennzeichnet, dass jedes Modul (II) einen Selektor (16, 43) zum Auswählen einer Funktionsart umfasst.

# FIG.1

FIG. 2

Port A    Port B

39    41

K THERMOCOUPLE    43

Pt 100    31

ANEMOMETRE

HYGROMETRE

40    42

°F/°C

32    32

38

30

**12.47** % RH

34

35  36  37

33    MIN  MAX  AVG

FIG.3

44

44

31

32

32

44

44

30

47

47

46

44

44